# EUROPÄISCHE PATENTSCHRIFT

(11) **EP 3 052 448 B1**
(45) Veröffentlichungstag und Bekanntmachung des Hinweises auf die Patenterteilung: **05.01.2022**
(21) Anmeldenummer: 14771818.3
(22) Anmeldetag: 10.09.2014
(51) Int. Cl.: C03C 3/06, G03F 7/20, G02B 5/08, C03B 19/14, G02B 7/00, C03B 32/00

(54) **SPIEGELBLANK FÜR EUV LITHOGRAPHIE OHNE AUSDEHNUNG UNTER EUV-BESTRAHLUNG**
MIRROR BLANK FOR EUV LITHOGRAPHY WITHOUT EXPANSION UNDER EUV RADIATION
POLI-MIROIR POUR LITHOGRAPHIE EUV SANS EXPANSION DUE AU RAYONNEMENT EUV

(30) Priorität: 30.09.2013 DE 102013219808
(43) Veröffentlichungstag der Anmeldung: 10.08.2016
(73) Patentinhaber: Heraeus Quarzglas GmbH & Co. KG, 63450 Hanau (DE)
(72) Erfinder: BECKER, Klaus, 63452 Hanau (DE); THOMAS, Stephan, 63538 Großkrotzenburg (DE)
(74) Vertreter: Heraeus IP
(86) Internationale Anmeldenummer: PCT/EP2014/069302
(87) Internationale Veröffentlichungsnummer: WO 2015/043957

(56) Entgegenhaltungen:
- WO-A2-2011/078414
- DE-A1-102012 201 075
- None

## Beschreibung

Die vorliegende Erfindung betrifft ein Substrat für einen EUV-Spiegel, das sich dadurch auszeichnet, dass die Verteilung der Nulldurchgangstemperatur an der optisch genutzten Oberfläche des Substrats von der statistischen Verteilung abweicht und das Substrat jeweils eine minimale und eine maximale Nulldurchgangstemperatur an der Oberfläche aufweist. Weiterhin betrifft die Erfindung ein Verfahren zur Herstellung eines Substrates für einen EUV-Spiegel, bei dem ein inhomogener Soll-Temperaturverlauf der Nulldurchgangstemperatur vorgegeben wird sowie die Verwendung der erfindungsgemäßen Substrate in der Fotolithographie.

In der EUV-Lithographie werden hochintegrierte Strukturen mittels elektromagnetischer Strahlung erzeugt. Die Wellenlänge der eingesetzten Strahlung bewegt sich dabei in einem Bereich von ungefähr 13 nm, also im Bereich von extrem-ultraviolettem Licht (EUV). Es werden EUV-Spiegel für EUV-Projektionssysteme verwendet, wobei die EUV-Spiegel zumindest ein Substrat und eine auf dem Substrat aufgebrachte reflektierende Mehrlagen-Beschichtung aufweisen. Das Substrat weist hierzu regelmäßig ein Nullausdehnungsmaterial und im Substrat ortsunabhängige Nulldurchgangstemperaturen der thermischen Ausdehnung auf. Der EUV-Spiegel weist bei Bestrahlung mit einer extrem ultravioletten Strahlung in einem EUV-Projektionssystem im EUV-Spiegel ortabhängige Betriebstemperaturen auf.

Die Spiegelsubstrate bestehen üblicher Weise aus hoch kieselsäurehaltigem Glas, das mit Titandioxid dotiert ist. Der eigentliche Spiegel wird durch mechanische Bearbeitung des Substrates und Beschichtung desselben mit einer Mehrlagenbeschichtung gewonnen. Dabei beträgt die maximale (theoretische) Reflektivität eines EUV-Spiegelelements etwa 70%, so dass ungefähr 30% der Strahlungsenergie in der Beschichtung oder in den oberflächennahen Schichten des Spiegelsubstrates absorbiert und dort in Wärme umgesetzt werden. Die in das Spiegelsubstrat eindringende Strahlung führt zu thermischen Volumenänderungen des Substrates, wobei es zu Verformungen der Oberfläche kommen kann. Schon kleinste Volumenänderungen im Bereich von 1 nm können zu merklichen Verschlechterungen und Verzerrungen der Abbildungsgüte führen. Dabei wird der Oberflächenbereich um die Auftrefffläche der Strahlung besonders belastet.

DE 10 2010 009 589 B4 beschreibt ein Verfahren zur Herstellung eines Rohling aus titandotiertem, hochkieselsäurehaltigem Glas für ein Spiegelsubstrat für den Einsatz in der EUV-Lithographie. Das Spiegelsubstrat weist einen zu verspiegelnden Oberflächenbereich auf, wobei das Glas für den Oberflächenbereich mittels Flammenhydrolyse erzeugt und ein vorgegebener Wasserstoffgehalt eingestellt wird.

US 2012/0264584 A1 offenbart ein Substrat für ein EUV-Lithographieprojektionssystem, das zwei gegensätzliche Oberflächen aufweist, deren Nulldurchgangstemperaturen sich um mindestens 5 °C unterscheiden.

DE 10 2011 085 358 B3 betrifft eine optische Anordnung für die EUV-Lithographie sowie ein Verfahren zu deren Konfigurierung. Die optische Anordnung, beispielsweise ein Projektionsobjektiv, umfasst dabei zwei Spiegelsubstrate mit jeweils unterschiedlichen thermischen Ausdehnungskoeffizienten, die so angeordnet sind, dass die durch die Verformung der Spiegel verursachte Verzerrung ausgeglichen wird.

DE102012201075 A1 offenbart eine optische Anordnung für die EUV Lithographie mit einer Temperiereinrichtung zur Temperierung, insbesondere zur Heizung des optischen Elements, d. h. des Substrats bzw. der optischen Oberfläche, sowie mit einer Temperatur-Kontrolleinrichtung, die zur Einstellung, insbesondere zur Regelung der mittleren Temperatur (bzw. der Betriebstemperatur) an der optischen Oberfläche ausgebildet ist.

US2012264584 A1 lehrt, dass die Nulldurchgangstemperatur in Gläsern durch Dotierung mit TiO2 einstellbar ist

Es besteht zunehmend Bedarf, EUV-Spiegelsubstrate bereitzustellen, die für den Einsatz in EUV-Spiegeln geeignet sind und eine präzise Bearbeitung von mikroelektronischen Bauteilen, zum Beispiel integrierten Schaltkreisen, insbesondere in der Halbleiterindustrie, ermöglichen. Es ist daher Aufgabe der vorliegenden Erfindung, ein Substrat für einen EUV-Spiegel sowie ein Verfahren zur Herstellung eines solchen bereitzustellen, das keine, oder zumindest nur eine minimale Ausdehnung unter definierten EUV-Bestrahlungsbedingungen aufweist, beispielsweise bei Einsatz in EUV-Lithographieverfahren, und so eine hohe Abbildungsgüte ermöglicht.

Die Erfindung wird durch die Ansprüche definiert.

Die Aufgabe wird erfindungsgemäß dadurch gelöst, dass die ortsabhängigen Nulldurchgangstemperaturen des Substrates über die Oberfläche des Substrates variieren und ihnen eine inhomogene, nicht-statistische Verteilung vorgegeben wird. Diese Verteilung entspricht im Idealfall der Verteilung der zu erwartenden Betriebstemperatur des Spiegels. Daher ist ein Gegenstand der vorliegenden Erfindung ein Substrat für einen EUV-Spiegel, das von der statistischen Verteilung abweichende Nulldurchgangstemperaturen an der Oberfläche aufweist, wobei das Substrat eine minimale Nulldurchgangstemperatur (T_{zcmin}) und eine maximale Nulldurchgangstemperatur (T_{zcmax}) an der Oberfläche aufweist, die um mehr als 1,5 K voneinander abweichen.

Unter einer von der statistischen Verteilung abweichenden Verteilung ist im Sinne der vorliegenden Erfindung eine nicht-willkürliche, nicht-lineare, inhomogene Verteilung zu verstehen. Vorzugsweise folgt die Nulldurchgangstemperatur einem festgelegten Verlauf beziehungsweise einer festgelegten Verteilung, der bzw. die sich an dem zu erwartenden Verlauf beziehungsweise an der zu erwartenden Verteilung der Betriebstemperatur des Spiegels orientiert.

Die Oberfläche des Substrats ist in einem EUV-Spiegel mit einer reflektierenden Mehrlagen-Beschichtung versehen, die als Oberfläche des Spiegels zu bezeichnen wäre. Die Oberfläche des Spiegels ist den Betriebsbedingungen direkt ausgesetzt. Oberfläche des Substrates im Rahmen der vorliegenden Erfindung meint die Oberfläche des Substrates, die in einem EUV-Spiegel der Mehrlagen-Beschichtung zugewandt ist. Oberfläche im Sinne der vorliegenden Erfindung kann sich sowohl auf eine zweidimensionale Abmessung als auch auf ein Volumenelement beziehen. Für den Fall, dass sich der Begriff Oberfläche des Substrates auf ein Volumenelement bezieht, handelt es sich bei dem Volumenelement vorzugsweise um ein Element, das eine Dicke von beispielsweise 2 cm bis 4 cm aufweist und das die äußere Begrenzung des Substrates bildet, die dem Betrieb zu gewandt ist.

Unter einem Substrat im Sinne der vorliegenden Erfindung ist ein Formkörper zu verstehen, der als Vorläufer beziehungsweise Rohling des eigentlichen EUV-Spiegels zu sehen ist. Aus diesem Vorläufer kann mit Hilfe weiterer Verfahrensschritte, beispielsweise durch das Aufbringen einer konkaven Spiegelform und polieren und reflektiv beschichten derselben, der eigentliche EUV-Spiegel gewonnen werden.

An die Substrate, die in der EUV-Lithographie eingesetzt werden, werden aufgrund der kurzwelligen Strahlung, der sie ausgesetzt sind, hohe materielle Anforderungen gestellt. Eine Materialgruppe, welche die hohen Anforderungen erfüllt, sind dotierte Quarzgläser. Weiterhin können die Eigenschaften des Quarzglases durch das Einbringen verschiedener Dotanden den jeweiligen Anforderungen angepasst werden. So kann beispielsweise durch eine geeignete Wahl der Dotanden der Brechungsindex oder die Viskosität des Glases variiert werden. Insbesondere trägt das Dotieren mit Titandioxid dazu bei, die thermische Ausdehnung des Quarzglases weiter zu minimieren.

Daher ist eine Ausführungsform der vorliegenden Erfindung bevorzugt, bei der das Substrat titanoxiddotiertes Quarzglas umfasst.

In einer bevorzugten Ausführungsform der vorliegenden Erfindung weist das Substrat Titandioxid in einer Menge von 5 Gew.-% bis 12 Gew.-%, vorzugsweise von 6 Gew.-% bis 10 Gew.-%, jeweils bezogen auf das Gesamtgewicht des Substrates, auf.

Es versteht sich, dass das Substrat weitere Dotanden aufweisen kann. So können beispielsweise unter anderem Alkalimetalle dazu verwendet werden, die Auswirkungen von Schlieren im Substrat zu verringern. Weiterhin können zum Beispiel weitere Dotanden eingesetzt werden, um die Viskosität oder die Brechungszahl des Substrates entsprechend den Betriebsbedingungen anzupassen.

In einer weiteren bevorzugten Ausführungsform umfasst das Substrat Glaskeramiken, bei denen das Verhältnis der Kristallphase zur Glasphase so eingestellt wird, dass sich die thermischen Ausdehnungskoeffizienten der unterschiedlichen Phasen nahe zu aufheben.

Es hat sich als vorteilhaft erwiesen, wenn das Substrat schichtförmig zusammengesetzt ist. Die Schichten können sich in ihrer Nulldurchgangstemperatur, der Verteilung der Nulldurchgangstemperatur oder anderen Merkmalen wie Blasen unterscheiden. Daher ist eine Ausführungsform der vorliegenden Erfindung bevorzugt, in der das Substrat mehrere Schichten umfasst. Die Dicke der einzelnen Schichten kann dabei variieren und unter Berücksichtigung der gewünschten Eigenschaften des Substrats frei gewählt werden. Die Anzahl der Schichten kann sich dabei beispielsweise in einem Bereich von 2 bis 4 bewegen.

Durch die Beleuchtung der Spiegel mit EUV-Strahlung wird der Spiegel im Betrieb erwärmt, wobei der Spiegel aufgrund einer inhomogenen Ausleuchtung durch einen ausgedehnten EUV-Strahlfleck mit einer räumlichen Intensitätsverteilung, eine Temperaturverteilung beziehungsweise ein Temperaturprofil aufweist, die bzw. das abhängig von der Auftrefffläche und/oder Intensitätsverteilung des EUV-Strahlflecks ist. Dieses Temperaturprofil findet sich analog auf der Oberfläche des Substrates. Dabei kann der Strahlfleck die gesamte Spiegeloberfläche oder auch nur einen Teil davon bestrahlen.

Um thermisch bedingten Deformationen des Substrates beziehungsweise des Spiegels entgegenzuwirken, ist es daher wünschenswert, dass die Verteilung der Nulldurchgangstemperatur diesem Temperaturprofil beziehungsweise dieser Temperaturverteilung angepasst ist. Folglich ist eine Ausführungsform bevorzugt, in der die Oberfläche des Substrats unterschiedliche Nulldurchgangstemperaturen aufweist, wobei die Nulldurchgangstemperatur vorzugsweise mindestens ein Maximum aufweist.

Daher ist eine Ausführungsform bevorzugt, in der das Substrat in den randfernen Bereichen eine Nulldurchgangstemperatur T_{zc1} und am Rand eine Nulldurchgangstemperatur T_{zc2} aufweist, wobei T_{zc1} um mindestens 1,5 °C höher ist als T_{zc2}.

In der Praxis weist das EUV-Strahlfeld üblicherweise ein oder mehrere Intensitätsmaxima auf. Dadurch ergibt sich ein Temperaturprofil, das sich im Wesentlichen dadurch auszeichnet, dass unterschiedliche Punkte unterschiedliche Temperaturen aufweisen, was dazu führt, dass die Nulldurchgangstemperaturen ebenfalls Differenzen aufweisen und sich eine maximale und eine minimale Nulldurchgangstemperatur auf der Oberfläche des Substrates finden. Für den Fall, dass die auf den EUV-Spiegel auftreffende Strahlung mehrere Intensitätsmaxima aufweist, weist die Temperaturverteilung auf der EUV-Spiegeloberfläche ebenfalls mehrere Maxima auf, wobei die Maxima auf der Oberfläche des Spiegels mit den Maxima der Intensität der Strahlung korrespondieren.

Folglich ist eine Ausführungsform bevorzugt, in der die Differenz zwischen T_{zcmax} und T_{zcmin} mindestens 2 K, weiter bevorzugt 3 K beträgt.

Weiterhin bevorzugt ist eine Ausführungsform des Substrates, bei der die Differenz zwischen T_{zcmax} und T_{zcmin} in einem Bereich von 2 bis 10 K, insbesondere von 2,5 bis 7 K, liegt.

Aus den üblichen Betriebsbedingungen, denen das Substrat ausgesetzt ist, ergibt sich in der Regel mindestens eine Stelle auf der Oberfläche des Substrates, an der das Substrat eine maximale Temperatur aufweist. Daher ist eine Ausführungsform bevorzugt, bei der die Verteilung der Nulldurchgangstemperaturen an der Oberfläche des Substrates mindestens ein lokales Maximum hat.

Weiterhin bevorzugt ist eine Ausführungsform, in der die Verteilung der Nulldurchgangstemperatur wenigstens teilweise einen im Wesentlichen stetigen Verlauf aufweist. So kann die Nulldurchgangstemperatur beispielsweise ausgehend von der Auftrefffläche des EUV-Strahlfeldes stetig von deren Mitte ausgehend aus abnehmen. Die Temperaturverteilung auf der Oberfläche des Spiegels, an die die Verteilung der Nulldurchgangstemperatur auf der Oberfläche des Substrates angepasst ist, ergibt sich dabei üblicherweise durch Wechselspiel zwischen der Erwärmung des Spiegels aufgrund der Bestrahlung mit einem EUV-Strahlfeld und der Wärmeabfuhr an die Umgebung. Weiterhin ist es möglich, die Temperaturverteilung durch gezielte Kühlung des Spiegels zu beeinflussen.

An die in der EUV-Lithographie eingesetzten Substrate werden hohe Anforderungen gestellt.

Die Substrate müssen über Eigenschaften, wie beispielsweise thermische Ausdehnungskoeffizienten oder Nulldurchgangstemperaturen, verfügen, die eine präzise Einstellung der Eigenschaften und eine sorgfältige Herstellung des Substrates erfordern.

Folglich ist ein weiterer Gegenstand der vorliegenden Erfindung ein Verfahren zur Herstellung eines Substrates für einen EUV-Spiegel umfassend die folgenden Schritte:
a) Vorgeben eines inhomogenen Soll-Temperaturverlaufs der Nulldurchgangstemperatur für das Substrat,
b) Herstellen des Substrates unter Einstellen des vorgegebenen ortsabhängigen Soll-Verlaufs der Nulldurchgangstemperatur.

Unter Soll-Temperaturverlauf im Sinne der vorliegenden Erfindung ist ein Temperaturverlauf zu verstehen, der vor der Herstellung des Substrates festgelegt wird. Dabei kann die Festlegung beispielsweise durch Messungen oder Berechnung erfolgen. Dieser Soll-Temperaturverlauf orientiert sich beispielsweise an den zu erwartenden Betriebstemperaturen des Spiegels, die abhängig von der Strahlungsquelle, der Anzahl und Anordnung der Strahlungsquellen sowie weiteren Prozessbedingungen variieren können. Die Verteilung der Nulldurchgangstemperatur im späteren Substrat ist diesem Verlauf angepasst. Dabei erfolgt die Anpassung vorzugsweise so, dass das Substrat unter Betriebsbedingungen keine thermisch bedingten Deformationen aufweist. Die üblicherweise auftretenden Verformungen werden dabei durch entsprechende Einstellung der Nulldurchgangstemperaturen im Substrat bzw. auf dessen Oberfläche weitestgehend ausgeglichen.

In einer bevorzugten Ausführungsform verläuft der Verlauf der Soll-Temperatur lateral. Unter einem lateralen Verlauf im Sinne der vorliegenden Erfindung ist insbesondere ein Verlauf zu verstehen, bei dem die Soll-Temperatur einem festgelegten Temperaturprofil auf der Oberfläche des Substrates folgt.

In einer bevorzugten Ausführung umfasst das erfindungsgemäße Verfahren die folgenden Schritte:
i) Abscheiden von Silizium enthaltenden Ausgangssubstanzen und Titan enthaltenden Ausgangssubstanzen unter Ausbildung eines TiO₂-dotierten Sootkörpers,
ii) Trocknen des Sootkörpers,
iii) Sintern des Sootkörpers unter Ausbildung des Rohlings,
iv) Homogenisierung des Rohlings und gegebenenfalls
v) Ausbilden eines Substrates.

Bei einem Sootkörper im Sinne der vorliegenden Erfindung handelt es sich um einen porösen, ungesinterten Körper aus Quarzglas.

Unter Rohling im Sinne der vorliegenden Erfindung ist ein gesintertes Werkstück aus Quarzglas zu verstehen, das für die Weiterverarbeitung bestimmt ist. Dabei kann die Weiterbearbeitung beispielsweise Formgebungsverfahren umfassen.

Vorzugsweise ist die Silizium enthaltende Ausgangssubstanz ausgewählt aus der Gruppe bestehend aus Octamethylcyclotetrasiloxan (OMCTS) und Siliziumtetrachlorid (SiCl₄).

Die Titan enthaltende Ausgangssubstanz ist vorzugsweise ausgewählt aus der Gruppe bestehend aus Titan-Isopropoxid [Ti(O*ⁱ*Pr)₄] und Titantetrachlorid (TiCl₄).

Das Abscheiden der Silizium enthaltenden Ausgangssubstanz und der Titan enthaltenden Ausgangssubstanz kann mittels üblichen, im Stand der Technik bekannten Methoden erfolgen. Vorzugsweise erfolgt das Abscheiden mittels Flammenhydrolyse, besonders bevorzugt mittels CVD-, OVD-, oder VAD-Verfahren.

In einem weiteren Verfahrensschritt wird der unter Schritt i) erhaltene Sootkörper getrocknet. Dabei kann die Trocknung sowohl bei Normaldruck (1 bar) als auch bei vermindertem Druck erfolgen. Weiterhin kann die Trocknung in Gegenwart von Inertgasen, wie beispielsweise Stickstoff oder Edelgase, erfolgen. Ebenso ist es möglich das Trocknen in einer oxidierenden Atmosphäre durchzuführen, um beispielsweise Reduktionsreaktionen von Ti⁴⁺ zu Ti³⁺ zu vermeiden, da Ti³⁺ zu einer verminderten Transmission des späteren Substrates führt. Um eine verbesserte Trocknungswirkung zu erzielen, kann die Trocknung gegebenenfalls in einer chlorhaltigen Atmosphäre vorgenommen werden.

Vorzugsweise erfolgt das Sintern des Sootkörpers in Schritt iii) bei Temperaturen in einem Bereich von 1000 bis 1700 °C, vorzugsweise in einem Bereich von 1300 bis 1500 °C.

Nach dem Homogensieren des Rohlings kann dieser gegebenenfalls, beispielsweise durch Formgebungsverfahren oder weitere Verfahrensschritte, zu einem Substrat weiterverarbeitet werden.

Zum Einstellen der Verteilung der Nulldurchgangstemperatur ist eine Ausführungsform bevorzugt, in der das Abscheiden der Ausgangssubstanzen schichtweise auf einem zylinderförmigen Rohling erfolgt. Auf diese Weise kann der Verlauf der Nulldurchgangstemperatur auf der späteren Oberfläche des Substrates nach vorher festgelegten Maßgaben eingestellt werden.

Es hat sich gezeigt, dass die Verteilung der Nulldurchgangstemperatur unter anderem von der TiO₂-Konzentration im Substrat abhängt. Somit ist es möglich, durch eine Variation des TiO₂-Gehalts die Verteilung der Nulldurchgangstemperatur zu beeinflussen. Daher ist eine Ausführungsform des erfindungsgemäßen Verfahrens bevorzugt, in dem die Menge der Titan enthaltenden Ausgangssubstanz während des Abscheidens variiert wird.

Die Verteilung der Nulldurchgangstemperatur folgt vorzugsweise einer nicht-statistischen Verteilung. Folglich ist eine Ausführungsform bevorzugt, bei der das Einstellen die Verteilung der Nulldurchgangstemperatur durch eine von der statistischen Verteilung abweichende Titanoxiddotierung erfolgt.

Weiterhin wurde gefunden, dass sich die Nulldurchgangstemperaturen eines Substrats sowie ihre Verteilung durch den OH-Gehalt im Sootkörper beeinflussen lassen. Dementsprechend ist eine Ausführungsform bevorzugt, in der das Einstellen die Verteilung der Nulldurchgangstemperatur durch eine von der statistischen Verteilung abweichende Verteilung des OH-Gehalts im Sootkörper erfolgt.

Bedingt durch Diffusionsprozesse während des Trocknens des Sootkörpers weist der Sootkörper üblicherweise eine Verteilung des OH-Gehalts auf, die in der Wandmitte ein Maximum aufweist und zu den Oberflächen hin abfällt. Daher wird durch eine geeignete Wahl der Prozessparameter wie Temperatur, Zeit und Druck, das OH-Profil derart beeinflusst, dass es den vorher festgelegten und gewünschten Vorgaben bezüglich des Verlaufs der Nulldurchgangstemperatur entspricht.

Weiterhin bevorzugt ist eine Ausführungsform der vorliegenden Erfindung, bei der das Einstellen der Verteilung der Nulldurchgangstemperatur durch eine von der statistischen Verteilung abweichende Verteilung eines Halogen-Codotanden erfolgt. Geeignete Halogen-Codotanden sind beispielsweise Siliziumtetrafluorid (SiF₄), Tetrafluormethan (CF₄) und Hexafluoroethan (C₂F₆). Der Halogen-Codotand kann beispielsweise während des Trocknungsprozesses eingebracht werden.

In einer weiter bevorzugten Ausführungsform erfolgt das Einstellen des Verlaufs der Nulldurchgangstemperatur durch die fiktiven Temperaturen des Substrats. Fiktive Temperatur im Rahmen der vorliegenden Erfindung ist die Temperatur, unterhalb derer sich die Bindungswinkel bei einem Abkühlvorgang im Glas nicht mehr ändern, d.h. die Bindungswinkel werden bei der jeweiligen fiktiven Temperatur "eingefroren".

Es hat sich gezeigt, dass die fiktive Temperatur durch gezielte Maßnahmen während des Abkühlprozesses beeinflusst werden kann. Daher erfolgt das Einstellen der fiktiven Temperaturen vorzugsweise durch Tempern mit Ringen, künstlichem Übermaß und/oder Zwangskühlung. Besonders bevorzugt erfolgt das Einstellen der fiktiven Temperatur derart, dass ihr Verlauf einem vorher festgelegten Profil folgt, das dem gewünschten Verlauf der Nulldurchgangstemperatur im späteren Substrat entspricht.

Das erfindungsgemäße Substrat sowie ein Substrat, das gemäß dem erfindungsgemäßen Verfahren erhältlich ist, zeichnen sich durch eine geringe thermische Verformung aus. Daher ist ein weiterer Gegenstand der vorliegenden Erfindung die Verwendung des erfindungsgemäßen Substrates oder eines Substrates erhältlich gemäß dem erfindungsgemäßen Verfahren für einen EUV-Spiegel oder in einem Lithographieverfahren, beispielsweise einem EUV-Lithographieverfahren, vorzugsweise zur Herstellung von Schaltkreisen oder Leiterbahnen.

Bei dem Einsatz von EUV-Spiegeln in Lithographieprozessen ist es wünschenswert, dass sich die Spiegel während des Prozesses nicht verformen, da es ansonsten zu Störungen in der Abbildungsgüte kommen kann. Dementsprechend muss sich das Substrat, das die Basis des Spiegels bildet, durch eine hohe Formtreue auch bei Erwärmung auszeichnen.

Daher ist eine Ausführungsform bevorzugt, bei der sich die Verwendung des erfindungsgemäßen Substrates oder eines Substrates, das gemäß dem erfindungsgemäßen Verfahren erhalten wurde, dadurch auszeichnet, dass der Verlauf der Nulldurchgangstemperatur im Substrat an den Verlauf der Betriebstemperatur des Spiegels angepasst ist. Auf diese Weise wird sichergestellt, dass eventuelle Deformationen des Spiegels durch das Substrat kompensiert werden, so dass insgesamt gesehen keine Formänderung zu beobachten ist.

Ein weiterer Gegenstand der vorliegenden Erfindung ist ein Lithographieverfahren, umfassend die folgenden Schritte:
a) Bereitstellen eines EUV-Spiegels mit einem Substrat und
b) Bereitstellen mindestens einer Strahlungsquelle, die während des Betriebs auf den EUV-Spiegel einwirkt,
wobei die Verteilung beziehungsweise der Verlauf der Nulldurchgangstemperatur im Substrat an den Verlauf der Betriebstemperatur des Spiegels angepasst ist.

Vorzugsweise ist die Verteilung beziehungsweise der Verlauf der Nulldurchgangstemperatur im Substrat derart an den Verlauf der Betriebstemperatur angepasst, dass der Spiegel insgesamt keine Formänderungen aufweist.

Die Erfindung soll anhand der folgenden Beispiele und Figuren näher erläutert werden, ohne dass diese als Einschränkung des Erfindungsgedanken zu verstehen sind.

### Beispiel 1: Einstellen der Verteilung der Nulldurchgangstemperatur durch Tempern mit künstlichem Übermaß

Durch Flammenhydrolyse von Octamethylcyclotetrasiloxan (OMCTS) und Titan-Isopropoxid [Ti(OⁱPr)₄] als Ausgangssubstanzen für die Bildung von SiO₂-TiO₂-Partikeln wird mit Hilfe des OVD-Verfahrens ein Sootkörper hergestellt, der mit ca. 8 Gew.-% TiO₂ dotiert ist.

Der Sootkörper wird bei einer Temperatur von 1150 °C in einem Heizofen mit einem Heizelement aus Grafit unter Vakuum dehydratisiert. Die Dehydratationsbehandlung endet nach 2 Stunden.

Danach wird der so getrocknete Sootkörper in einem Sinterofen bei einer Temperatur von ca. 1500 °C unter vermindertem Druck (10⁻² mbar) zu einem transparenten Rohling aus TiO₂ - SiO₂-Glas verglast. Der mittlere OH-Gehalt des Glases liegt bei etwa 170 Gew.-ppm.

Das Glas wird anschließend durch thermisch mechanische Homogenisierung (Verdrillen) und Bildung eines Zylinders aus TiO₂ - SiO₂-Glas homogenisiert. Hierzu wird ein stabförmiger Ausgangskörper in eine mit einem Knallgasbrenner ausgestattete Glasdrehbank eingespannt und anhand eines Umformprozesses homogenisiert, wie er in der EP 673 888 A1 zum Zweck der vollständigen Entfernung von Schichten beschrieben ist. Dabei wird der Ausgangskörper mittels des Knallgasbrenners lokal auf über 2000 °C erhitzt und dabei erweicht. Dabei werden dem Knallgasbrenner auf 1 Mol Sauerstoff 1,8 Mol Wasserstoff zugeführt und damit eine oxidierend wirkende Knallgasflamme erzeugt.

Durch Relativbewegung der beiden Halterungen zueinander wird der Ausgangs-körper um seine Längsachse verdrillt, wobei die erweichte Glasmasse unter Bildung eines Drillkörpers in radialer Richtung intensiv durchmischt wird. Auf diese Weise wird ein länglicher Drillkörper mit einem Durchmesser von etwa 90 mm und einer Länge von etwa 635 mm erhalten.

Aus dem Rohling wird danach eine runde Platte aus TiO₂-SiO₂-Glas mit einem Durchmesser von 30 cm und einer Dicke von 5,7 cm geformt.

Zum Abbau mechanischer Spannungen sowie zur Einstellung einer vorgegebenen fiktiven Temperatur wird die Glasplatte einer Temperbehandlung unterzogen. Dabei soll die fiktive Temperatur am Rand des Rohlings tiefer als in der Mitte sein, um außen eine niedrigere Nulldurchgangstemperatur des Ausdehnungskoeffizienten zu erreichen. Hierfür werden die Stirnseite und die äußersten 50 mm entlang des Umfangs des Rohlings durch 50 mm dicke Hilfsstücke aus Quarzglas isoliert und so in einen Temperofen eingebaut. Hierbei wird die Glasplatte während einer Haltezeit von 8 Stunden unter Luft und_Atmosphärendruck auf 1080 °C erhitzt und anschließend mit einer Abkühlrate von 4 °C/h auf eine Temperatur von 850 °C abgekühlt. Während dieser Abkühlung kann aufgrund der Isolation im Randbereich des Rohlings die fiktive Temperatur länger (tiefer) relaxieren als in der Mitte der Oberfläche, wodurch die gewünschte Verteilung erreicht wird. Daraufhin wird die TiO₂-SiO₂-Glasplatte mit einer höheren Abkühlrate von 50 °C/h auf eine Temperatur von 300 °C abgekühlt, woraufhin der Ofen abgestellt und die Glasplatte der freien Abkühlung des Ofens überlassen wird.

Zur Weiterverarbeitung wird durch mechanische Bearbeitung eine Oberflächenschicht der Glasplatte abgenommen, so dass sich ein Durchmesser von 29,4 cm und eine Dicke d von 5,1 cm ergeben.

Die so erhaltene Platte besteht aus besonders hochwertigem, homogenisiertem, hochkieselsäurehaltigem Glas, das 8 Gew.-% Titanoxid enthält. Der OH-Gehalt beträgt 170 Gew.-ppm. Die über die gesamte Dicke gemessene mittlere fiktive Temperatur beträgt 968 °C, und fällt zum Rand hin um 6 °C ab. Damit fällt die Nulldurchgangstemperatur vom Zentrum radial nach außen hin um 2 °C ab.

### Beispiel 2: Einstellen der Verteilung der Nulldurchgangstemperatur durch angepasste Titanoxidverteilung

Durch Flammenhydrolyse von Octamethylcyclotetrasiloxan (OMCTS) und Titan-Isopropoxid [Ti(O*ⁱ*Pr)₄] als Ausgangssubstanzen für die Bildung von SiO₂-TiO₂-Partikeln wird mit Hilfe des OVD-Verfahrens ein Sootkörper hergestellt. Während des Aufbaus wird der Anteil des Titan-Precursors [Ti(O*ⁱ*Pr)₄] in einem Maße reduziert, dass die TiO₂-Konzentration zu Beginn 8,20% beträgt und zeitlich abnimmt, so dass sie gegen Ende nur noch bei 8,05% liegt.

Der Sootkörper wird bei einer Temperatur von 1150 °C in einem Heizofen mit einem Heizelement aus Grafit unter Vakuum dehydratisiert. Die Dehydratationsbehandlung endet nach 2 Stunden.

Danach wird der so getrocknete Sootkörper in einem Sinterofen bei einer Temperatur von ca. 1500 °C unter vermindertem Druck (10⁻² mbar) zu einem transparenten Rohling aus TiO₂-SiO₂-Glas verglast. Der mittlere OH-Gehalt des Glases liegt bei etwa 180 Gew.-ppm.

Das Glas wird anschließend analog zu Beispiel 1 homogenisiert. Es wird ein länglicher Drillkörper mit einem Durchmesser von etwa 90 mm und einer Länge von etwa 620 mm erhalten. Durch die Homogenisierung wird die Titanoxidverteilung rotationssymmetrisch. Aufgrund des Gradienten der Titanoxidkonzentration im Rohkörper fällt die Titanoxidverteilung von der Mitte radial nach außen hin um 0,05% ab. Die Stärke des Abfalls kann während der Flammenhydrolyse leicht eingestellt werden.

Aus dem Rohling wird danach eine runde Platte aus TiO₂-SiO₂-Glas mit einem Durchmesser von 30 cm und einer Dicke von 5,5 cm geformt.

Zum Abbau mechanischer Spannungen sowie zur Einstellung einer vorgegebenen fiktiven Temperatur wird die Glasplatte einer Temperbehandlung unterzogen. Hierbei wird die Glasplatte während einer Haltezeit von 8 Stunden unter Luft und Atmosphärendruck auf 1080 °C erhitzt und anschließend mit einer Abkühlrate von 4 °C/h auf eine Temperatur von 950 °C abgekühlt. Bei dieser Temperatur wird die Platte für 4h gehalten, um örtliche Variationen der fiktiven Temperatur zu vermeiden. Daraufhin wird die TiO₂-SiO₂-Glasplatte mit einer höheren Abkühlrate von 50 °C/h auf eine Temperatur von 300 °C abgekühlt, woraufhin der Ofen abgestellt und die Glasplatte der freien Abkühlung des Ofens überlassen wird.

Zur Weiterverarbeitung wird durch mechanische Bearbeitung eine Oberflächenschicht der Glasplatte abgenommen, so dass sich ein Durchmesser von 28,6 cm und eine Dicke d von 5,0 cm ergeben.

Die so erhaltene Platte besteht aus besonders hochwertigem, homogenisiertem, hochkieselsäurehaltigem Glas, das im Mittel etwa 8,11 Gew.-% Titanoxid enthält. Der Titanoxid-Anteil nimmt radial von der Mitte nach außen um 0.05% ab. Der OH-Gehalt beträgt 180 Gew.-ppm. Die über die gesamte Dicke gemessene mittlere fiktive Temperatur beträgt 972 °C, und fällt zum Rand hin um weniger als 1°C ab. Damit fällt die Nulldurchgangstemperatur vom Zentrum radial nach außen hin um 2,2 °C ab.

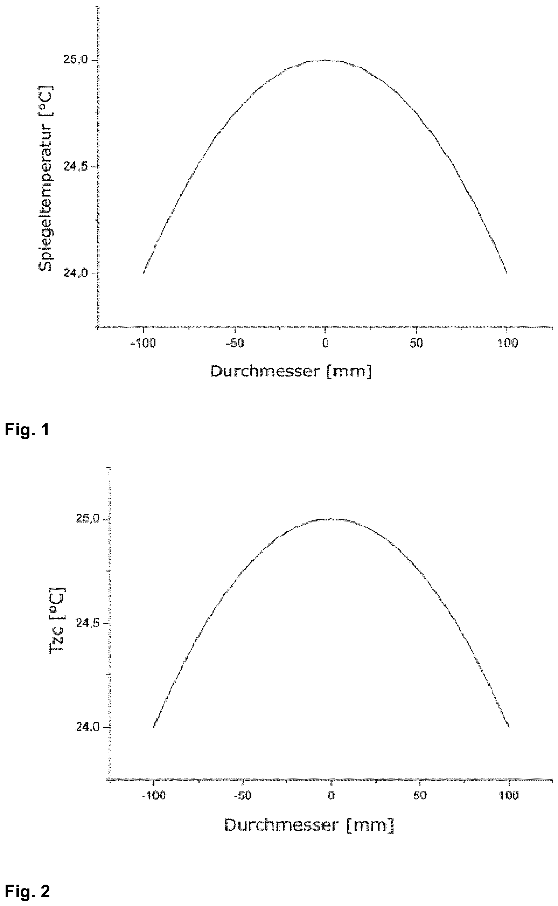

Figur 1 zeigt den Verlauf der Betriebstemperatur eines EUV-Spiegels bei zentraler Bestrahlung entlang einer durch den Mittelpunkt des Substrats verlaufender Achse, wobei sich der Spiegel vornehmlich in der Mitte erwärmt.

Figur 2 zeigt den Verlauf der Nulldurchgangstemperatur (T_{zc}) eines Substrates entlang einer durch den Mittelpunkt des Substrats verlaufender Achse, wobei der Verlauf der Nulldurchgangstemperatur dem Verlauf der Betriebstemperatur des Spiegels in Figur 1 entspricht. Auf diese Weise lässt sich eine minimale Verzerrung des Spiegels erreichen.

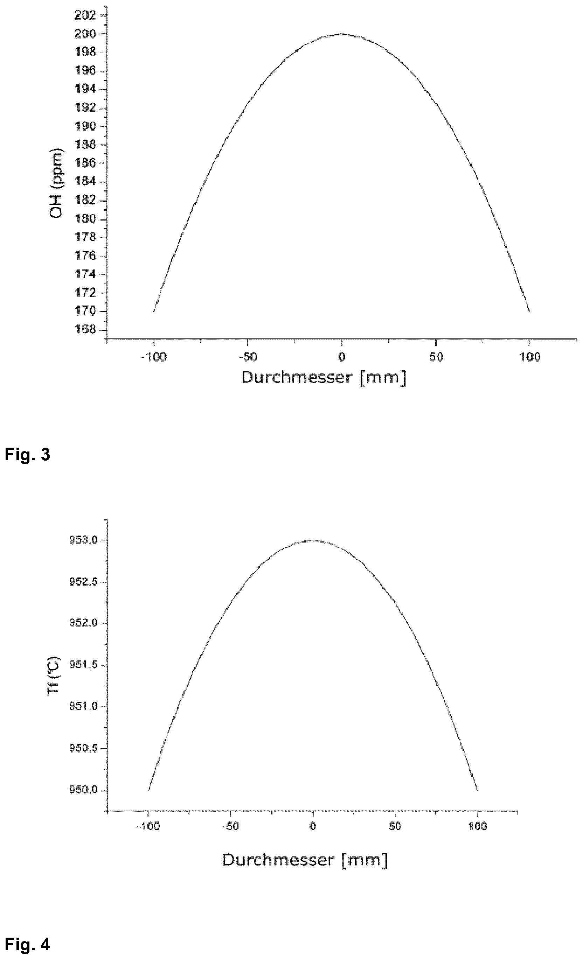

Figur 3 zeigt den Verlauf des OH-Gehaltes des in Figur 2 gezeigten Substrates entlang einer durch den Mittelpunkt des Substrats verlaufender Achse. Der Verlauf des OH-Gehaltes lässt sich durch gezieltes Trocknen des SiO₂-Sootkörpers einstellen. In diesem Fall ist es von Vorteil, wenn die fiktive Temperatur (T_{f}) des Substrates einen möglichst flachen Verlauf zeigt, um eine negative, d.h. gegenläufige Beeinflussung des OH-Gehalts durch die fiktive Temperatur zu verhindern. Dieser flache Verlauf der fiktiven Temperatur lässt sich beispielsweise durch Tempern, also durch langes Halten bei einer festen Temperatur, erzielen.

Wie bereits ausgeführt, lässt sich der Verlauf der Nulldurchgangstemperatur im Substrat alternativ durch die fiktiven Temperaturen im Substrat festlegen. Figur 4 zeigt den Verlauf der fiktiven Temperatur eines Substrates entlang einer durch den Mittelpunkt des Substrats verlaufender Achse, das einen in Figur 2 gezeigten Verlauf der Nulldurchgangstemperatur aufweist. Einen nach außen hin abfallenden Verlauf der fiktiven Temperatur, wie in Figur 4 gezeigt, lässt sich beispielsweise durch Isolierung des Substratumfangs, beispielsweise durch Temperringe, während des Abkühlens erreichen. Alternativ können die größeren Flächen des Substrates, insbesondere die Oberfläche, durch einen Luftstrom zwangsgekühlt und so eine höhere fiktive Temperatur eingestellt werden. Weiterhin ist es möglich, den lateralen Verlauf der fiktiven Temperatur durch die Verwendung von Deckelplatten oder Sandbädern zu beeinflussen. So kann die Deckelplatte zum Beispiel nur bestimmte Bereiche der Oberfläche abdecken. Ebenso können die fiktiven Temperaturen durch die Verwendung von Deckelplatten eingestellt werden, die unterschiedliche Dicken und damit ein unterschiedliches Isolationsverhalten aufweisen.

Das Einstellen des axialen Verlaufs der fiktiven Temperatur im Substrat lässt sich beispielsweise durch das gezielte Ausnutzen von Wärmesenken im Temperofen über die Höhe des Substrates erreichen.

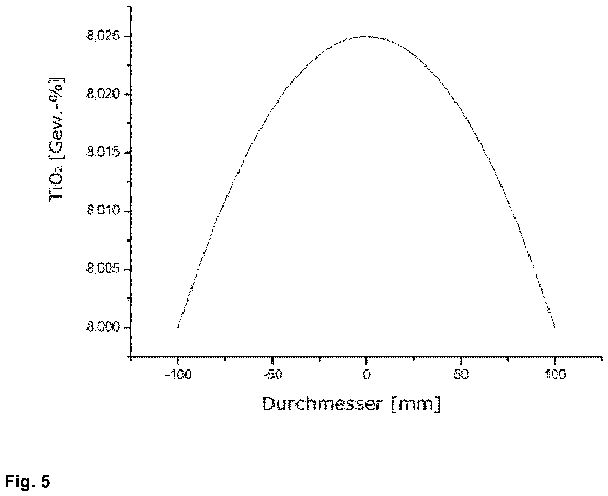

Figur 5 zeigt den Verlauf der TiO₂-Konzentration eines Substrates entlang einer durch den Mittelpunkt des Substrats verlaufender Achse, das einen in Figur 2 wiedergegebenen Nulldurchgangstemperaturverlauf aufweist. Das TiO₂-Konzentrationsprofil lässt sich beispielsweise über einen schichtweisen Aufbau des Substrats erreichen, bei dessen Herstellung die Konzentration der TiO₂-enthaltenden Ausgangsverbindung während des Abscheideprozesses variiert wird.

## Patentansprüche

1. Substrat für einen EUV-Spiegel **dadurch gekennzeichnet, dass** das Substrat von der statistischen Verteilung abweichende Nulldurchgangstemperaturen an der Oberfläche aufweist, wobei das Substrat eine minimale Nulldurchgangstemperatur (T_{zcmin}) und eine maximale Nulldurchgangstemperatur (T_{zcmax}) an der Oberfläche aufweist, die um mehr als 1,5 K voneinander abweichen,
wobei das Substrat in den randfernen Bereichen eine Nulldurchgangstemperatur Tzc1 und am Rand eine Nulldurchgangstemperatur Tzc2 aufweist, wobei Tzc1 um mindestens 1,5 °C höher ist als Tzc2,
wobei die Verteilung der Nulldurchgangstemperaturen an der Oberfläche mindestens ein lokales Maximum hat.

2. Substrat gemäß Anspruch 1, **dadurch gekennzeichnet, dass** das Substrat titanoxiddotiertes Quarzglas umfasst.

3. Substrat gemäß einem oder mehreren der Ansprüche 1 oder 2, **dadurch gekennzeichnet, dass** das Substrat Titandioxid in einer Menge von 5 Gew.-% bis 12 Gew.-%, vorzugsweise von 6 Gew.-% bis 10 Gew.-%, jeweils bezogen auf das Gesamtgewicht des Substrates, aufweist.

4. Substrat gemäß einem oder mehrerer der Ansprüche 1 bis 3, **dadurch gekennzeichnet, dass** das Substrat mehrere Schichten umfasst.

5. Substrat gemäß einem oder mehreren der Ansprüche 1 bis 4, **dadurch gekennzeichnet, dass** die Differenz zwischen T_{zcmax} und T_{zcmin} mindestens 2 K, weiter bevorzugt mindestens 3 K beträgt.

6. Substrat gemäß einem oder mehreren der vorangehenden Ansprüche, **dadurch gekennzeichnet, dass** die Differenz zwischen T_{zcmax} und T_{zcmin} in einem Bereich von 2 bis 10 K, insbesondere in einem Bereich von 2,5 bis 7 K beträgt.

7. Substrat gemäß einem oder mehreren der vorangehenden Ansprüche, **dadurch gekennzeichnet, dass** die Verteilung der Nulldurchgangstemperatur wenigstens teilweise einen im Wesentlichen stetigen Verlauf aufweist.

8. Verfahren zur Herstellung eines Substrates für einen EUV-Spiegel umfassend die folgenden Schritte:
a. Vorgeben eines inhomogenen Soll-Temperaturverlaufs der Nulldurchgangstemperatur für das Substrat,
b. Herstellen des Substrates unter Einstellen des vorgegebenen ortsabhängigen Soll-Verlaufs der Nulldurchgangstemperatur, wobei das Herstellen des Substrates die folgenden Schritte umfasst:
i. Abscheiden von Silizium enthaltenden Ausgangssubstanzen und Titan enthaltenden Ausgangssubstanzen unter Ausbildung eines Ti02-dotierten Sootkörpers,
ii. Trocknen des Sootkörpers,
iii. Sintern des Sootkörpers unter Ausbildung des Rohlings
iv. Homogenisieren des Rohlings und gegebenenfalls
v. Ausbilden eines Substrates
wobei
der Verlauf der Soll-Temperatur lateral verläuft,
wobei das Substrat eine minimale Nulldurchgangstemperatur (Tzcmin) und eine maximale Nulldurchgangstemperatur (Tzcmax) an der Oberfläche aufweist, die um mehr als 1,5 K voneinander abweichen,
wobei das Substrat in den randfernen Bereichen eine Nulldurchgangstemperatur Tzc1 und am Rand eine Nulldurchgangstemperatur Tzc2 aufweist, wobei Tzc1 um mindestens 1,5 °C höher ist als Tzc2,
wobei die Verteilung der Nulldurchgangstemperaturen an der Oberfläche des Substrates mindestens ein lokales Maximum hat.

9. Verfahren gemäß Anspruch 8, **dadurch gekennzeichnet, dass** die Menge der Titan enthaltenden Ausgangssubstanz während des Abscheidens variiert wird.

10. Verfahren gemäß Anspruch 9, **dadurch gekennzeichnet, dass** das Einstellen der Verteilung der Nulldurchgangstemperatur durch eine von der statistischen Verteilung abweichende Titanoxiddotierung erfolgt.

11. Verfahren gemäß Anspruch 8, **dadurch gekennzeichnet, dass** das Einstellen der Verteilung der Nulldurchgangstemperatur durch eine von der statistischen Verteilung abweichende Verteilung des OH-Gehalts im Sootkörper erfolgt.

12. Verfahren gemäß Anspruch 8, **dadurch gekennzeichnet, dass** das Einstellen der Verteilung der Nulldurchgangstemperatur durch eine von der statistischen Verteilung abweichende Verteilung eines Halogen-Codotanden erfolgt.

13. Verfahren gemäß Anspruch 8, **dadurch gekennzeichnet, dass** das Einstellen der fiktiven Temperaturen durch Tempern mit Ringen, künstlichem Übermaß und/oder Zwangskühlung erfolgt.

14. Verwendung eines Substrates gemäß einem oder mehrerer der Ansprüche 1 bis 7 oder eines Substrats, erhalten gemäß einem Verfahren gemäß einem oder mehrerer der Ansprüche 8 bis 13 für einen EUV-Spiegel oder in einem Lithographieverfahren.

## Claims

1. Substrate for an EUV mirror, **characterized in that** the substrate has zero-crossing temperatures at the surface that deviate from the statistical distribution, wherein the substrate has a minimum zero-crossing temperature (T_{zcmin}) and a maximum zero-crossing temperature (T_{zcmax}) at the surface which deviate from each other by more than 1.5 K, wherein the substrate has a zero-crossing temperature Tzc1 in the regions remote from the edge and a zero-crossing temperature Tzc2 at the edge, wherein Tzc1 is at least 1.5°C higher than Tzc2,
wherein the distribution of the zero-crossing temperatures at the surface has at least one local maximum.

2. Substrate according to claim 1, **characterized in that** the substrate comprises titanium oxide-doped quartz glass.

3. Substrate according to one or more of claims 1 or 2, **characterized in that** the substrate has titanium dioxide in a quantity of from 5% by weight to 12% by weight, preferably of from 6% by weight to 10% by weight, in each case based on the total weight of the substrate.

4. Substrate according to one or more of claims 1 to 3, **characterized in that** the substrate comprises a plurality of layers.

5. Substrate according to one or more of claims 1 to 4, **characterized in that** the difference between T_{zcmax} and T_{zcmin} is at least 2 K, more preferably at least 3 K.

6. Substrate according to one or more of the preceding claims, **characterized in that** the difference between T_{zcmax} and T_{zcmin} is in a range of from 2 to 10 K, in particular in a range of from 2.5 to 7 K.

7. Substrate according to one or more of the preceding claims, **characterized in that** the distribution of the zero-crossing temperature at least partially has a substantially continuous profile.

8. Method for producing a substrate for an EUV mirror, comprising the following steps:
a. specifying an inhomogeneous setpoint temperature profile of the zero-crossing temperature for the substrate,
b. producing the substrate while setting the specified location-dependent setpoint profile of the zero-crossing temperature, wherein the production of the substrate comprises the following steps:
i. depositing starting substances containing silicon and starting substances containing titanium to form a Ti02- doped soot body,
ii. drying the soot body,
iii. sintering the soot body to form the blank,
iv. homogenizing the blank, and optionally
v. forming a substrate,
wherein
the profile of the setpoint temperature runs laterally,
wherein the substrate has a minimum zero-crossing temperature (Tzcmin) and a maximum zero-crossing temperature (Tzcmax) at the surface which deviate from each other by more than 1.5 K,
wherein the substrate has a zero-crossing temperature Tzc1 in the regions remote from the edge and a zero-crossing temperature Tzc2 at the edge, wherein Tzc1 is at least 1.5°C higher than Tzc2,
wherein the distribution of the zero-crossing temperatures at the surface of the substrate has at least one local maximum.

9. Method according to claim 8, **characterized in that** the amount of the starting substance containing titanium is varied during the deposition.

10. Method according to claim 9, **characterized in that** the distribution of the zero-crossing temperature is set by means of a titanium oxide doping that deviates from the statistical distribution.

11. Method according to claim 8, **characterized in that** the distribution of the zero-crossing temperature is set by a distribution of the OH content in the soot body that deviates from the statistical distribution.

12. Method according to claim 8, **characterized in that** the distribution of the zero-crossing temperature is set by a distribution of a halogen co-dopant that deviates from the statistical distribution.

13. Method according to claim 8, **characterized in that** the fictional temperatures are set by tempering with rings, artificial oversize and/or forced cooling.

14. Use of a substrate according to one or more of claims 1 to 7 or of a substrate obtained according to a method according to one or more of claims 8 to 13 for an EUV mirror or in a lithography method.

## Revendications

1. Substrat pour un miroir EUV **caractérisé en ce que** le substrat présente sur la surface des températures de passage par zéro différentes de la distribution statistique, le substrat présentant sur la surface une température de passage par zéro minimale (T_{zcmin}) et une température de passage par zéro maximale (T_{zcmax}), qui diffèrent l'une de l'autre de plus de 1,5 K, le substrat présentant dans les zones éloignées des bords une température de passage par zéro Tzc1 et près du bord une température de passage par zéro Tzc2, Tzc1 étant d'au moins 1,5 °C plus élevée que Tzc2,
la distribution des températures de passage par zéro sur la surface ayant au moins un maximum local.

2. Substrat selon la revendication 1, **caractérisé en ce que** le substrat comprend du verre de quartz dopé avec de l'oxyde de titane.

3. Substrat selon une ou plusieurs des revendications 1 ou 2, **caractérisé en ce que** le substrat présente de l'oxyde de titane dans une quantité de 5 % en poids à 12 % en poids, de préférence de 6 % en poids à 10 % en poids, respectivement par rapport au poids total du substrat.

4. Substrat selon une ou plusieurs des revendications 1 à 3, **caractérisé en ce que** le substrat comprend plusieurs couches.

5. Substrat selon une ou plusieurs des revendications 1 à 4, **caractérisé en ce que** la différence entre T_{zcmax} et T_{zcmin} est d'au moins 2 K, mieux encore d'au moins 3 K.

6. Substrat selon une ou plusieurs des revendications précédentes, **caractérisé en ce que** la différence entre T_{zcmax} et T_{zcmin} est comprise dans une plage de 2 à 10 K, en particulier dans une plage de 2,5 à 7 K.

7. Substrat selon une ou plusieurs des revendications précédentes, **caractérisé en ce que** la distribution de la température de passage par zéro présente au moins partiellement un profil essentiellement continu.

8. Procédé de production d'un substrat pour un miroir EUV comprenant les étapes suivantes :
a. prédéfinition d'un profil de température de consigne non homogène de la température de passage par zéro pour le substrat,
b. production du substrat en réglant le profil de consigne prédéfini dépendant de l'emplacement de la température de passage par zéro, la production du substrat comprenant les étapes suivantes :
i. dépôt de substances initiales contenant du silicium et de substances initiales contenant du titane avec la formation d'un corps de suie dopé avec Ti02,
ii. séchage du corps de suie,
iii. frittage du corps de suie en formant une ébauche
iv. homogénéisation de l'ébauche et, le cas échéant,
v. formation d'un substrat
dans lequel
le profil de la température de consigne s'étend latéralement,
le substrat présentant sur la surface une température de passage par zéro minimale (Tzcmin) et une température de passage par zéro maximale (Tzcmax), qui diffèrent l'une de l'autre de plus de 1,5 K,
le substrat présentant dans les zones éloignées des bords une température de passage par zéro Tzc1 et près du bord une température de passage par zéro Tzc2, Tzc1 étant d'au moins 1,5 °C plus élevée que Tzc2,
la distribution des températures de passage par zéro sur la surface du substrat ayant au moins un maximum local.

9. Procédé selon la revendication 8, **caractérisé en ce que** la quantité de la substance initiale contenant du titane est variée au cours du dépôt.

10. Procédé selon la revendication 9, **caractérisé en ce que** le réglage de la distribution de la température de passage par zéro est effectué par un dopage avec de l'oxyde de titane différent de la distribution statistique.

11. Procédé selon la revendication 8, **caractérisé en ce que** le réglage de la distribution de la température de passage par zéro est effectué par une distribution de la teneur en OH dans le corps de suie différente de la distribution statistique.

12. Procédé selon la revendication 8, **caractérisé en ce que** le réglage de la distribution de la température de passage par zéro est effectué par une distribution d'un codopage avec de l'halogène différente de la distribution statistique.

13. Procédé selon la revendication 8, **caractérisé en ce que** le réglage des températures fictives est effectué par l'exposition à un recuit avec des anneaux, un excès artificiel et/ou un refroidissement forcé.

14. Utilisation d'un substrat selon une ou plusieurs des revendications 1 à 7 ou d'un substrat obtenu selon un procédé selon une ou plusieurs des revendications 8 à 13 pour un miroir EUV ou dans un procédé de lithographie.
